(19) **Europäisches Patentamt**
**European Patent Office**
**Office européen des brevets**

(11) **EP 3 974 853 B1**

(12) **FASCICULE DE BREVET EUROPEEN**

(45) Date de publication et mention
de la délivrance du brevet:
**28.06.2023 Bulletin 2023/26**

(51) Classification Internationale des Brevets (IPC):
***G01R 31/367*** (2019.01)    ***G01R 31/392*** (2019.01)

(52) Classification Coopérative des Brevets (CPC):
**G01R 31/392; G01R 31/367;** Y02E 60/10

(21) Numéro de dépôt: **21197959.6**

(22) Date de dépôt: **21.09.2021**

(54) **PRÉDICTION DE L'ÉTAT DE SANTÉ FUTUR DES CELLULES D'UNE BATTERIE ÉLECTRIQUE**

VORHERSAGE DES ZUKÜNFTIGEN STATE OF HEALTH VON ZELLEN EINER ELEKTRISCHEN BATTERIE

PREDICTION OF THE FUTURE STATE OF HEALTH OF CELLS OF AN ELECTRIC BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.09.2020 FR 2009734**

(43) Date de publication de la demande:
**30.03.2022 Bulletin 2022/13**

(73) Titulaires:
• **Commissariat à l'Energie Atomique et aux Energies Alternatives**
**75015 Paris (FR)**
• **BHG**
**68220 Attenschwiller (FR)**

(72) Inventeurs:
• **KLEIN, Jean-Marie**
**38054 GRENOBLE CEDEX 09 (FR)**
• **MONTARU, Maxime**
**38054 GRENOBLE CEDEX 09 (FR)**
• **VINIT, Laurent**
**38054 GRENOBLE CEDEX 09 (FR)**

(74) Mandataire: **Cabinet Beaumont**
**4, Place Robert Schuman**
**B.P. 1529**
**38025 Grenoble Cedex 1 (FR)**

(56) Documents cités:
**DE-A1-102014 200 645     US-A1- 2010 250 162**

US-A1- 2018 059 192

• POURMOUSAVI S ALI ET AL: "A novel algorithm to integrate battery Cyclic and Calendar agings within a single framework", 2016 IEEE POWER & ENERGY SOCIETY INNOVATIVE SMART GRID TECHNOLOGIES CONFERENCE (ISGT), IEEE, 6 septembre 2016 (2016-09-06), pages 1-5, XP033020140, DOI: 10.1109/ISGT.2016.7781028
• BREMER ILKA ET AL: "Investigation of li-ion battery state of health detection in electric vehicles - a comparison of simulation results and field measurement", 2016 IEEE TRANSPORTATION ELECTRIFICATION CONFERENCE AND EXPO, ASIA-PACIFIC (ITEC ASIA-PACIFIC), IEEE, 1 juin 2016 (2016-06-01), pages 18-23, XP032924039, DOI: 10.1109/ITEC-AP.2016.7512915
• DOUKAS GEORGIOS ET AL: "Battery operation cycle management for electric vehicles with battery switching technology", 2014 IEEE TRANSPORTATION ELECTRIFICATION CONFERENCE AND EXPO (ITEC), IEEE, 15 juin 2014 (2014-06-15), pages 1-6, XP032778628, DOI: 10.1109/ITEC.2014.6861864
• LACEY GILLIAN ET AL: "The effect of cycling on the state of health of the electric vehicle battery", 2013 48TH INTERNATIONAL UNIVERSITIES' POWER ENGINEERING CONFERENCE (UPEC), IEEE, 2 septembre 2013 (2013-09-02), pages 1-7, XP032778139, DOI: 10.1109/UPEC.2013.6715031

**Description**

Domaine technique

La présente description concerne le domaine des batteries électriques de façon générale, et vise plus particulièrement la prédiction de l'état de santé ou état de vieillissement futur des cellules d'une batterie.

Technique antérieure

Une batterie électrique est un groupement de plusieurs cellules rechargeables reliées en série et/ou en parallèle entre deux noeuds ou bornes de fourniture de tension.

De façon classique, une batterie électrique intègre un dispositif électronique de gestion, généralement désigné par le terme BMS, de l'anglais "Battery Management System", destiné à mettre en oeuvre des fonctions diverses telles que des fonctions d'équilibrage des cellules, des fonctions de protection, etc.

Dans certaines batteries, le BMS peut être adapté à déterminer un indicateur représentatif du vieillissement des cellules de la batterie, généralement appelé SOH, de l'anglais "State of Health" pour état de santé. A un instant donné de la vie d'une cellule, le SOH peut être défini comme étant le rapport de la capacité de la cellule (c'est-à-dire la charge maximale qu'est capable de stocker et délivrer la cellule) à l'instant considéré, sur une capacité de référence de la cellule, par exemple sa capacité nominale (c'est-à-dire la capacité indiquée par le constructeur), ou sa capacité mesurée à l'état neuf.

Les méthodes connues d'estimation du SOH mises en oeuvre par un BMS de batterie électrique sont basées sur des mesures de signaux physiques, typiquement des mesures de courant et/ou de tension aux bornes des cellules. L'estimation de SOH fournie est ainsi représentative de l'état de santé des cellules au moment de la mesure. Des exemples d'art antérieur peuvent être vus dans US 2010/250162 A1, US 2018/059192 A1, DE 10 2014 200645 A1, "A novel algorithm to integrated battery cyclic and calendar agings within a single framework", par Pourmousavi S Ali et al, et "Investigation of li-ion battery state of health détection in electric vehicles - a comparison of simulation results and field measurement" par Bremer Ilka et al.

Dans certaines applications, il serait souhaitable de pouvoir prédire l'évolution future du vieillissement des cellules d'une batterie, afin par exemple de programmer en avance une opération de maintenance ou de remplacement de la batterie.

Résumé de l'invention

Pour cela, un mode de réalisation prévoit une batterie électrique comprenant un dispositif électronique de gestion configuré pour :

a) mesurer et mémoriser un profil d'utilisation de la batterie ; et
b) calculer une valeur représentative de l'état de santé futur de la batterie en tenant compte dudit profil d'utilisation mesuré à l'étape a), en se basant sur un modèle prédéfini de vieillissement de la batterie, dans laquelle le modèle de vieillissement comprend une ou plusieurs tables de vieillissement prédéfinies stockées dans un circuit mémoire du dispositif électronique de gestion, le modèle de vieillissement comprend une première table de vieillissement modélisant le vieillissement calendaire de la batterie, la première table de vieillissement est une table à trois dimensions contenant, pour chaque combinaison d'une valeur d'état de santé, d'une valeur d'état de charge, et d'une valeur de température parmi :

- une pluralité de valeurs de d'état de santé prédéfinies ;
- une pluralité de valeurs de d'état de charge prédéfinies ; et
- une pluralité de valeurs de de température prédéfinies, une valeur représentative de la perte de capacité de la batterie pendant un intervalle de temps prédéfini, le modèle de vieillissement comprend en outre une deuxième table de vieillissement modélisant le vieillissement par cyclage de la batterie, la première table de vieillissement est une table à quatre dimensions contenant, pour chaque combinaison d'une valeur d'état de santé, d'une valeur d'état de charge, d'une valeur de température, et d'une valeur de courant de sollicitation de la batterie parmi :
- une pluralité de valeurs de d'état de santé prédéfinies ;
- une pluralité de valeurs de d'état de charge prédéfinies ;
- une pluralité de valeurs de de température prédéfinies ; et
- une pluralité de valeurs de courant de sollicitation de la batterie prédéfinies,

une valeur représentative de la perte de capacité de la batterie pendant un intervalle de temps prédéfini, le dispositif électronique de gestion est configuré pour, à l'étape b), estimer, à partir du modèle et en fonction du profil d'utilisation mesuré à l'étape a), une perte future de capacité de la batterie, et en déduire ladite valeur représentative de l'état de santé futur de la batterie.

Selon un mode de réalisation, le dispositif électronique de gestion est configuré pour réitérer l'étape b) successivement une pluralité de fois en modifiant à chaque itération l'horizon de prédiction, de façon à déterminer une durée de vie estimée de la batterie.

Un autre mode de réalisation prévoit un procédé mis en oeuvre dans une batterie électrique comprenant un dispositif électronique de gestion selon la revendication 3.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente de façon schématique un exemple d'une batterie électrique selon un mode de réalisation ; et
la figure 2 représente de façon schématique un exemple d'un procédé de prédiction de l'état de santé futur des cellules d'une batterie électrique selon un mode de réalisation.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation du dispositif électronique de gestion adapté à mettre en oeuvre les procédés de prédiction de SOH décrits n'a pas été détaillée, la réalisation d'un tel dispositif étant à la portée de la personne du métier à partir des indications fonctionnelles de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

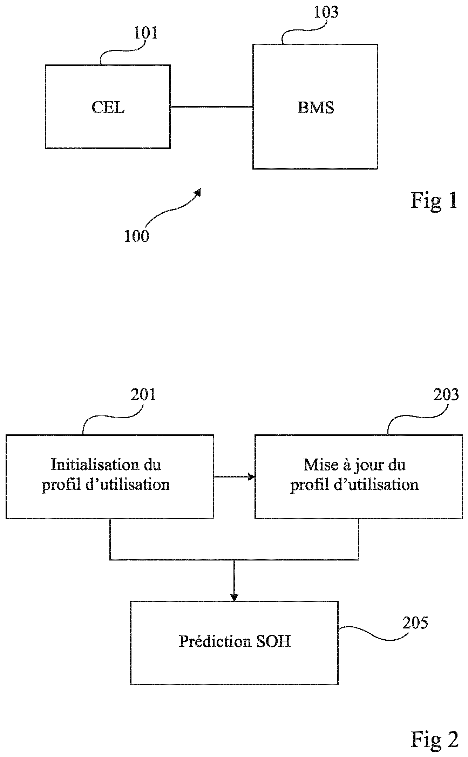

La figure 1 représente de façon schématique un exemple d'une batterie électrique 100 selon un mode de réalisation.

La batterie 100 comprend un ensemble 101 (CEL) d'une ou plusieurs cellules élémentaires de stockage d'énergie électrique (non détaillées sur la figure), par exemple des accumulateurs électrochimiques, par exemple des accumulateurs au lithium, connectées en série et/ou en parallèle entre deux bornes (non détaillées sur la figure) de fourniture de tension de la batterie.

La batterie 100 comprend en outre un dispositif électronique de gestion 103 (BMS) relié, par exemple connecté, aux cellules de l'ensemble 101. Le dispositif 103 comporte divers capteurs (non détaillés sur la figure) adaptés à mesurer des paramètres physiques relatifs aux cellules élémentaires de la batterie ou à leur environnement. A titre d'exemple, le dispositif 103 comprend un ou plusieurs capteurs de tension et/ou un ou plusieurs capteurs de courant adaptés à mesurer des tensions et/ou des courants entre les bornes de cellules élémentaires et/ou de groupes de cellules élémentaires de la batterie. Le dispositif 103 peut en outre comporter un ou plusieurs capteurs de température. Le dispositif 103 comprend en outre un circuit électronique de traitement (non détaillé sur la figure), par exemple un microcontrôleur couplé à un circuit mémoire, adapté à mettre en oeuvre des procédés de traitement des données mesurées par les capteurs. Le dispositif 103 peut être configuré pour mettre en oeuvre des fonctions diverses telles que des fonctions d'équilibrage des cellules, des fonctions de protection, des fonctions de calcul de l'état de charge et/ou de l'état de santé présent des cellules de la batterie, etc.

Selon un aspect d'un mode de réalisation, le dispositif électronique de gestion 103 de la batterie est configuré pour mettre en oeuvre un procédé de prédiction de l'état de santé futur des cellules de la batterie.

Des modèles mathématiques adaptés à simuler l'évolution future du vieillissement d'une batterie en fonction de profils d'utilisation moyens envisagés de la batterie ont déjà été proposés. De tels modèles sont classiquement utilisés en phase de conception pour dimensionner la batterie d'un produit et estimer sa durée de vie et le moment où elle devra être remplacée. Toutefois, l'estimation réalisée est alors basée sur des profils d'utilisation qui ne correspondent pas nécessairement à l'utilisation réelle de la batterie. Si les profils d'utilisation réels de la batterie diffèrent des profils utilisés lors de la simulation, la durée de vie réelle de la batterie peut être différente de la durée de vie estimée, ce qui peut poser problème.

Selon un aspect d'un mode de réalisation, le dispositif électronique de gestion 103 de la batterie 100 de la figure 1 est configuré pour mesurer et mémoriser un profil d'utilisation réel de la batterie, et estimer l'état de santé futur des cellules de la batterie en tenant compte de ce profil d'utilisation.

La figure 2 représente de façon schématique un exemple d'un procédé de prédiction de l'état de santé futur des cellules de la batterie 100 de la figure 1, mis en oeuvre par le dispositif électronique de gestion 103 de la batterie.

Le procédé de prédiction mis en oeuvre dans cet exemple est basé sur un modèle de vieillissement dit empirique, paramétré au moyen d'une base de données constituée de résultats d'essais d'endurance de cellules élémentaires de même nature que les cellules de la batterie 100. L'étendue de la campagne d'essais d'endurance est déterminée en fonction du nombre de paramètres susceptibles d'influencer l'état de santé des cellules.

A titre d'exemple, le modèle utilisé prend en compte deux types de dégradation, une dégradation dite calendaire, qui survient tout au long de la vie des cellules de la batterie, que celles-ci soient soumises ou non à une sollicitation électrique, et une dégradation dite de cyclage, qui survient lorsque les cellules de la batterie sont soumises à une dégradation électrique.

A titre d'exemple, le modèle utilisé est défini par les équations suivantes :

[Math 1]

$$\frac{\partial Q_{loss}}{\partial t} = \frac{J_{cal}(T, SOC)}{1 + A.Q_{loss}}$$

[Math 2]

$$\frac{\partial Q_{loss}}{\partial Q_{th}} = \frac{J_{cyc}(T, SOC, I)}{1 + A.Q_{loss}}$$

[Math 3]

$$dQ_{loss} = \frac{\partial Q_{loss}}{\partial t} dt + \frac{\partial Q_{loss}}{\partial Q_{th}} dQ_{th}$$

Où :

$Q_{loss}$ désigne la capacité perdue de la batterie, en ampères-heures (Ah), par rapport à sa capacité nominale d'origine (par exemple à l'état neuf) ;
$J_{cal}$ désigne la vitesse de dégradation de la batterie liée au vieillissement calendaire, en ampères-heures par seconde (Ah.s$^{-1}$) ;
$J_{cyc}$ désigne la vitesse de dégradation de la batterie liée au vieillissement par cyclage, en ampères-heures par ampère-heure (Ah.Ah$^{-1}$) ;
$Q_{th}$ désigne la quantité de charges transitée dans la batterie (en charge ou en décharge), en ampères-heures (Ah) ;
t désigne la durée, en secondes (s) ;
T désigne la température des cellules de la batterie, en degrés (°C) ;
SOC désigne l'état de charge de la batterie, en pourcents (%) ;
I désigne le courant de sollicitation de la batterie (en charge ou en décharge), en ampères (A) ; et
A désigne un facteur de forme (coefficient fixe prédéterminé) représentatif de la non linéarité de l'évolution de la perte de capacité, en Ah$^{-1}$.

L'équation Math 1 exprime la perte de capacité liée au vieillissement calendaire. Dans cet exemple, cette perte dépend principalement de deux paramètres, à savoir la température T, et l'état de charge SOC de la batterie.

L'équation Math 2 exprime la perte de capacité liée au vieillissement par cyclage. Dans cet exemple, cette perte dépend principalement de trois paramètres, à savoir la température T, l'état de charge SOC, et le niveau de sollicitation I de la batterie.

L'équation Math 3 permet de déterminer la perte de capacité totale $dQ_{loss}$ pour une période de temps *dt* et une quantité de charge transitée $dQ_{th}$ données, en cumulant les pertes calendaires et les pertes de cyclage.

Dans cet exemple, le procédé comprend une étape 201 de stockage, dans une mémoire du dispositif 103, d'un profil initial d'utilisation de la batterie. Le profil initial peut être défini à la conception du produit (non détaillé) comprenant la batterie. Le profil initial peut correspondre à un profil moyen d'utilisation envisagé lors de la conception du produit. Par profil d'utilisation, on entend ici un ensemble d'une ou plusieurs courbes représentatives chacune de l'évolution d'un paramètre physiques relatif aux cellules de la batterie ou à leur environnement.

A titre d'exemple, le profil d'utilisation comprend :

- une courbe de température, représentative de l'évolution, en fonction du temps, de la température des cellules de la batterie, sur une période de temps prédéterminée, par exemple de l'ordre de la durée de vie maximale estimée de la batterie ; et
- une courbe d'état de charge, représentative de l'évolution, en fonction du temps, de l'état de charge des cellules de la batterie, sur ladite période de temps prédéterminée.

Ces deux premières courbes permettent de prédire la perte future de capacité liée au vieillissement calendaire, sur la base de l'équation Math 1 susmentionnée.

Le profil d'utilisation peut en outre comprendre une courbe de courant représentative de l'évolution, en fonction du temps, du courant de sollicitation (en charge ou en décharge), sur ladite période de temps prédéterminée.

Cette dernière courbe permet, prise en combinaison avec les deux premières courbes, de prédire la perte future de capacité liée au cyclage, sur la base de l'équation Math 2 susmentionnée.

En pratique, chacune des courbes susmentionnées peut être stockée dans une mémoire du dispositif électronique de gestion de la batterie sous la forme d'une série de valeurs discrètes.

L'étape 201 d'initialisation du profil d'utilisation est par exemple mise en oeuvre une seule fois à la fabrication de la batterie, ou lors de l'assemblage de la batterie dans le produit dans lequel elle est destinée à être intégrée.

Le procédé de la figure 1 comprend en outre, après l'étape 201, une étape 203 de mise à jour du profil d'utilisation à partir de données réelles d'utilisation mesurées par le dispositif électronique de gestion 103. A titre d'exemple, le dispositif électronique de gestion 103 peut être configuré pour mesurer l'évolution effective de la température et/ou de l'état de charge des cellules de la batterie en fonction du temps. De plus, le dispositif 103 peut être configuré pour mesurer l'évolution effective de la température et/ou de l'état de charge et/ou de la charge transitée et/ou du courant de sollicitation des cellules de la batterie en fonction du temps. Les courbes de données d'utilisation réelles peuvent être stockées sous la forme de séries de valeurs discrètes. A titre d'exemple, les données mesurées viennent progressivement remplacer les données du profil initial chargé à l'étape 201, tout au long de la vie de la batterie.

Le procédé de la figure 2 comprend en outre une étape 205 de prédiction de l'état de santé futur des cellules de la batterie, à partir du profil d'utilisation stocké dans le dispositif 103. La prédiction réalisée à l'étape 205 est basée sur un modèle de vieillissement prédéfini, par exemple un modèle empirique paramétré à la conception de la batterie, par exemple un modèle du type défini par les équations Math 1, Math 2 et Math 3 ci-dessus. A titre d'exemple, lors de l'étape 203, plusieurs prédictions successives à des horizons de prédiction distincts peuvent être réalisées, de façon à estimer la durée de vie restante des cellules de la batterie, c'est-à-dire la période restante à l'issue de laquelle le SOH des cellules passera sous un seuil de fin de vie prédéfini. La durée de vie restante estimée pourra être fournie à l'utilisateur par le biais d'une interface utilisateur, non détaillée. A l'état neuf, la prédiction est réalisée sur la base du profil d'utilisation initial chargé à l'étape 201. Ainsi, la durée de vie estimée à l'étape 205 sera sensiblement identique à la durée de vie nominale annoncée par le fabriquant. Après un certain temps d'utilisation de la batterie, la prise en compte des profils d'utilisation réels mesurés à l'étape 203 conduira à progressivement affiner l'estimation de durée de vie des cellules de la batterie.

Les étapes 203 et 205 peuvent être réitérées une pluralité de fois tout au long de la vie de la batterie.

En pratique, les équations mathématiques du modèle de vieillissement peuvent comprendre des opérations de calcul relativement complexes à mettre en oeuvre. Les dispositifs électroniques de gestion de batterie ayant généralement des ressources calculatoires limitées, ces dernières peuvent s'avérer insuffisantes pour réaliser les calculs de prédiction de SOH à partir des équations analytiques du modèle.

Ainsi, de façon préférentielle, le modèle de vieillissement est stocké dans une mémoire du dispositif électronique de gestion, sous la forme de tables de résultats calculées ex-situ par ordinateur à la conception de la batterie à partir des équations analytiques du modèle. L'étape 205 de prédiction du SOH futur des cellules consiste alors essentiellement en une lecture des tables du modèle, ne nécessitant pas de calculs complexes.

A nouveau, le modèle de vieillissement peut être décomposé en un modèle de vieillissement calendaire et un modèle de vieillissement par cyclage, dont les composantes s'additionnent pour obtenir le vieillissement complet des cellules de la batterie. A titre d'exemple, on prévoit de stocker dans le dispositif électronique de gestion 103 une première table de résultats appelée $LUT_{aging,cal}$ modélisant le vieillissement calendaire, et une deuxième table de résultats appelée $LUT_{cycl,cal}$, modélisant le vieillissement par cyclage.

La perte de capacité des cellules à un instant t donné peut alors s'exprimer comme suit :

[Math 4]

$$Q_{loss,t} = \left(Q_{loss,t-1,cal} + LUT_{aging,cal}\left(Q_{loss,t-1,cal}, T_t, SOC_t\right) \cdot \Delta t\right)$$
$$+ \left(Q_{loss,t-1,cycl} + LUT_{aging,cycl}\left(Q_{loss,t-1,cycl}, I_t, T_t, SOC_t\right) \cdot \Delta t\right)$$

$Q_{loss,t}$ désigne la perte totale de capacité (par rapport à la capacité nominale $C_{nom}$ de la batterie à l'état neuf) due au vieillissement à un instant t, où t désigne le temps discrétisé avec un pas de discrétisation $\Delta t$.

$Q_{loss,t-1,cal}$ désigne la perte totale de capacité (par rapport à la capacité nominale $C_{nom}$ de la batterie à l'état neuf) due au vieillissement calendaire à l'instant t-1.

$LUT_{aging,cal}(Q_{loss,t-1,cal}, T_t, SOC_t) \cdot \Delta t$ désigne la perte supplémentaire de capacité due au vieillissement calendaire entre les instants t-1 et t, $T_t$ et $SOC_t$ désignant respectivement la température et l'état de charge de la batterie à l'instant t.

$Q_{loss,t-1,cycl}$ désigne la perte totale de capacité (par rapport à la capacité nominale $C_{nom}$ de la batterie à l'état neuf) due au cyclage à l'instant t-1.

$LUT_{aging,cycl}(Q_{loss,t-1,cycl}, I_t, T_t, SOC_t) \cdot \Delta t$ désigne la perte supplémentaire de capacité due au cyclage entre les instants t-1 et t, $I_t$ désignant le courant de sollicitation des cellules de la batterie à l'instant t.

Le SOH des cellules de la batterie à l'instant t peut ensuite être calculé comme suit :

[Math 5]

$$SOH_t = \frac{C_{nom} - Q_{loss,t}}{C_{nom}} \cdot 100$$

Par soucis de simplification, on considère par la suite uniquement la contribution calendaire du vieillissement.

L'équation Math 4 ci-dessus peut alors être simplifiée comme suit :

[Math 6]

$$Q_{loss,t} = Q_{loss,t-1,cal} + LUT_{aging,cal}\left(Q_{loss,t-1,cal}, T_t, SOC_t\right) \cdot \Delta t$$

Dans cet exemple, la table $LUT_{aging,cal}$ modélisant le vieillissement calendaire peut être défini par trois paramètres, à savoir le pas $\Delta T$ de discrétisation (ou précision) de la température, par exemple de 1°C, le pas $\Delta SOC$ de discrétisation (ou précision) de l'état de charge, par exemple de 1%, et le pas $\Delta SOH$ de discrétisation (ou précision) de l'état de santé, par exemple de 1%. On désigne ci-après par K le nombre de valeurs discrètes de SOH considérées lors de la modélisation, par L le nombre de valeurs discrètes de température considérées lors de la modélisation, et par M le nombre de valeurs discrètes d'état de charge considérées lors de la modélisation, avec :

[Math 7]

$$K = (SOH_{max} - SOH_{min})/\Delta SOH$$

[Math 8]

$$L = (T_{max} - T_{min})/\Delta T$$

[Math 9]

$$M = (SOC_{max} - SOC_{min})/\Delta SOC$$

Où $SOH_{max}$ et $SOH_{min}$ désignent respectivement la valeur maximale (par exemple 100%) et la valeur minimale (par exemple le seuil de fin de vie des cellules) que peut prendre le SOH tout au long de la durée de vie des cellules de la batterie. Où $T_{max}$ et $T_{min}$ désignent respectivement la valeur maximale et la valeur minimale que peut prendre la température des cellules lors du fonctionnement de la batterie. Et où $SOC_{max}$ et $SOC_{min}$ désignent respectivement la valeur maximale (par exemple 100%) et la valeur minimale (par exemple 0%) que peut prendre l'état de charge des cellules.

La table $LUT_{aging,cal}$ est ainsi une table à trois dimensions comprenant K*L*M valeurs $Q_{loss,SOHk,Tl,SOCm,\Delta t}$, avec k entier allant de 1 à K, l entier allant de 1 à L, et m entier allant de 1 à L.

Chaque valeur $Q_{loss,SOHk,Tl,SOCm,\Delta t}$ correspond à la capacité perdue du fait du vieillissement calendaire pendant une intervalle de durée $\Delta t$, pour des cellules présentant un état de santé SOH=SOHk, une température T=Tl, et un état de charge SOC=SOCm. Comme indiqué précédemment, les K*L*M valeurs $Q_{loss,SOHk,Tl,SOCm,\Delta t}$ peuvent être calculées ex-situ par ordinateur à la conception de la batterie à partir des équations analytiques du modèle, puis stockées dans un circuit mémoire du dispositif électronique de gestion 103. L'intervalle $\Delta t$ correspond au pas de discrétisation temporel du profil d'utilisation de la batterie mémorisé dans le dispositif 103, par exemple égal à 1 seconde.

Lors de l'étape de prédiction 205 du procédé de la figure 2, on vient lire dans la table $LUT_{aging,cal}$ les valeurs successives de perte de capacité pour chaque intervalle de temps $\Delta t$ en fonction des valeurs de température et d'état de charge du profil d'utilisation mémorisé dans le dispositif 103, et en tenant compte du SOH estimé des cellules. Après chaque lecture d'une valeur dans la table $LUT_{aging,cal}$ et avant la lecture de la valeur suivante, le SOH estimé est mis à jour en tenant compte de la valeur lue.

La résolution en température, en état de charge et en SOH de la table détermine la précision et donc la fiabilité de la prédiction mise en oeuvre à l'étape 205. En contrepartie, plus la résolution de la table est élevée, plus la quantité de mémoire nécessaire à son stockage est importante.

Pour limiter la quantité de mémoire nécessaire tout en contrôlant l'erreur par rapport au modèle mathématique analytique, on pourra avantageusement prévoir une résolution variable d'un ou plusieurs paramètres de la table. A titre d'exemple, le pas $\Delta SOH$ de discrétisation du SOH peut être relativement élevé pour des valeurs de SOH élevées, puis relativement faible pour des valeurs de SOH plus faible. Ceci permet d'obtenir une bonne précision de la cartographie vis-à-vis du modèle pour réaliser des estimations de durée de vie (projections) sur des durées longues (20 ans par exemple). En effet, pour l'utilisateur, la précision requise dans l'estimation du SOH est généralement plus importante lorsque le SOH est faible, c'est-à-dire lorsque les cellules approchent de leur fin de vie, que lorsque le SOH est élevé, c'est-à-dire lorsque les cellules ont une durée de vie restante relativement élevée.

En pratique, la construction de la table $LUT_{aging,cycl}$ de modélisation du vieillissement par cyclage est similaire à ce qui a été décrit ci-dessus concernant le vieillissement calendaire, à ceci près que la table $LUT_{aging,cycl}$ comporte une dimension supplémentaire :

[Math 10]

$$N = (I_{max} - I_{min})/\Delta I$$

Où $I_{max}$ et $I_{min}$ désignent respectivement la valeur maximale et la valeur minimale que peut prendre le courant de sollicitation des cellules (en valeur absolue), et où $\Delta I$ désigne le pas de discrétisation (ou précision) du courant.

La table $LUT_{aging,cycl}$ est ainsi une table à quatre dimensions comprenant K*L*M*N valeurs $Q_{loss,SOHk,Tl,SOCm,In,\Delta t}$, avec n entier allant de 1 à N. Chaque valeur $Q_{loss,SOHk,Tl,SOCm,In,\Delta t}$ correspond à la capacité perdue du fait du vieillissement par cyclage pendant une intervalle de durée $\Delta t$, pour des cellules présentant un état de santé SOH=SOHk, une température T=Tl, un état de charge SOC=SOCm, et soumises à un courant I=In.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation ne se limitent pas à l'exemple particulier de modèle de vieillissement décrit par les équations Math 1, Math 2 et Math 3 susmentionnées, mais peuvent plus généralement, être adaptés à tout modèle connu de vieillissement de cellules élémentaires de stockage d'énergie électrique.

**Revendications**

1. Batterie électrique (100) comprenant un dispositif électronique de gestion (103) configuré pour :

   a) mesurer et mémoriser un profil d'utilisation de la batterie ; et
   b) calculer une valeur représentative de l'état de santé futur de la batterie (100) en tenant compte dudit profil d'utilisation mesuré à l'étape a), en se basant sur un modèle prédéfini de vieillissement de la batterie, **caractérisée en ce que** le modèle de vieillissement comprend, stockées dans un circuit mémoire du dispositif électronique de gestion (103), une première table de vieillissement prédéfinie modélisant le vieillissement calendaire de la batterie et une deuxième table de vieillissement prédéfinie modélisant le vieillissement par cyclage de la batterie, dans laquelle la première table de vieillissement est une table à trois dimensions contenant, pour chaque combinaison d'une valeur d'état de santé, d'une valeur d'état de charge, et d'une valeur de température parmi :

- une pluralité de valeurs d'état de santé prédéfinies ;
- une pluralité de valeurs d'état de charge prédéfinies ; et
- une pluralité de valeurs de température prédéfinies, une valeur représentative de la perte de capacité de la batterie pendant un intervalle de temps prédéfini,

dans laquelle la deuxième table de vieillissement est une table à quatre dimensions contenant, pour chaque combinaison d'une valeur d'état de santé, d'une valeur d'état de charge, d'une valeur de température, et d'une valeur de courant de sollicitation de la batterie parmi :

- une pluralité de valeurs d'état de santé prédéfinies ;
- une pluralité de valeurs d'état de charge prédéfinies ;
- une pluralité de valeurs de température prédéfinies ; et
- une pluralité de valeurs de courant de sollicitation de la batterie prédéfinies,

une valeur représentative de la perte de capacité de la batterie pendant un intervalle de temps prédéfini, et dans laquelle le dispositif électronique de gestion (103) est configuré pour, à l'étape b), estimer, à partir du modèle et en fonction du profil d'utilisation mesuré à l'étape a), une perte future de capacité de la batterie, et en déduire ladite valeur représentative de l'état de santé futur de la batterie.

2. Batterie selon la revendication 1, dans laquelle le dispositif électronique de gestion (103) est configuré pour réitérer l'étape b) successivement une pluralité de fois en modifiant à chaque itération l'horizon de prédiction, de façon à déterminer une durée de vie estimée de la batterie.

3. Procédé mis en oeuvre dans une batterie électrique (100) comprenant un dispositif électronique de gestion (103), comprenant les étapes suivantes :

a) mesurer et mémoriser (203), au moyen du dispositif électronique de gestion (103), un profil d'utilisation de la batterie ; et

b) calculer (205), au moyen du dispositif électronique de gestion (103), une valeur représentative de l'état de santé futur de la batterie en tenant compte du profil d'utilisation mesuré à l'étape a), en se basant sur un modèle prédéfini de vieillissement de la batterie, **caractérisé en ce que** le modèle de vieillissement comprend, stockées dans un circuit mémoire du dispositif électronique de gestion (103), une première table de vieillissement prédéfinie modélisant le vieillissement calendaire de la batterie et une deuxième table de vieillissement prédéfinie modélisant le vieillissement par cyclage de la batterie, dans lequel la première table de vieillissement est une table à trois dimensions contenant, pour chaque combinaison d'une valeur d'état de santé, d'une valeur d'état de charge, et d'une valeur de température parmi :

- une pluralité de valeurs d'état de santé prédéfinies ;
- une pluralité de valeurs d'état de charge prédéfinies ; et
- une pluralité de valeurs de température prédéfinies, une valeur représentative de la perte de capacité de la batterie pendant un intervalle de temps prédéfini,

dans lequel la deuxième table de vieillissement est une table à quatre dimensions contenant, pour chaque combinaison d'une valeur d'état de santé, d'une valeur d'état de charge, d'une valeur de température, et d'une valeur de courant de sollicitation de la batterie parmi :

- une pluralité de valeurs d'état de santé prédéfinies ;
- une pluralité de valeurs d'état de charge prédéfinies ;
- une pluralité de valeurs de température prédéfinies ; et
- une pluralité de valeurs de courant de sollicitation de la batterie prédéfinies,
une valeur représentative de la perte de capacité de la batterie pendant un intervalle de temps prédéfini, et dans lequel le dispositif électronique de gestion (103) est configuré pour, à l'étape b), estimer, à partir du modèle et en fonction du profil d'utilisation mesuré à l'étape a), une perte future de capacité de la batterie, et en déduire ladite valeur représentative de l'état de santé futur de la batterie.

**Patentansprüche**

1. Elektrische Batterie (100), die eine elektronische Verwaltungsvorrichtung (103) aufweist, die konfiguriert ist zum:

   a) Messen und Speichern eines Batterienutzungsprofils; und
   b) Berechnen eines Werts, der für den zukünftigen Gesundheitszustand der Batterie (100) repräsentativ ist, unter Berücksichtigung des in Schritt a) gemessene Nutzungsprofils, basierend auf einem vordefinierten Batteriealterungsmodell, **dadurch gekennzeichnet, dass** das Alterungsmodell, gespeichert in einer Speicherschaltung der elektronischen Verwaltungsvorrichtung (103), Folgendes aufweist eine erste vordefinierte Alterungstabelle, die die kalendarische Alterung der Batterie modelliert, und eine zweite vordefinierte Alterungstabelle, die die Alterung durch Zyklisieren der Batterie modelliert, wobei die erste Alterungstabelle eine dreidimensionale Tabelle ist, die für jede Kombination eines Zustandswerts, eines Ladezustandswerts und eines Temperaturwerts unter:

   - einer Vielzahl von vordefinierten Zustandswerten;
   - einer Vielzahl von vordefinierten Werten für den Ladezustand; und
   - einer Vielzahl von vordefinierten Temperaturwerten, einen Wert enthält, der repräsentativ ist für den Verlust der Batteriekapazität während eines vordefinierten Zeitintervalls,

   wobei die zweite Alterungstabelle eine vierdimensionale Tabelle ist, die für jede Kombination eines Gesundheitszustandswerts, eines Ladezustandswerts, eines Temperaturwerts und eines Werts eines Vorspannungsstroms der Batterie unter:

   - einer Vielzahl von vordefinierten Zustandswerten;
   - einer Vielzahl von vordefinierten Ladezustandswerten;
   - einer Vielzahl von vordefinierten Temperaturwerten; und
   - einer Vielzahl von vordefinierten Werten des Vorspannungsstroms der Batterie,

   einen Wert enthält, der für den Verlust der Batteriekapazität während eines vordefinierten Zeitintervalls repräsentativ ist,
   und wobei die elektronische Verwaltungsvorrichtung (103) konfiguriert ist zum in Schritt b) Schätzen, aus dem Modell und gemäß dem in Schritt a) gemessenen Nutzungsprofil, eines zukünftigen Verlustes an Batteriekapazität und Ableiten daraus des Werts, der den zukünftigen Gesundheitszustand der Batterie darstellt.

2. Batterie nach Anspruch 1, wobei die elektronische Verwaltungsvorrichtung (103) so konfiguriert ist zum Wiederholen des Schritts b) mehrere Male nacheinander, indem sie bei jeder Iteration den Vorhersagehorizont modifiziert, um eine geschätzte Batterielebensdauer zu bestimmen.

3. Verfahren, das in einer elektrischen Batterie (100) mit einer elektronischen Verwaltungsvorrichtung (103) implementiert ist, aufweisend die folgenden Schritte:

   a) Messen und Speichern (203) eines Batterieverwendungsprofils durch die elektronische Verwaltungsvorrichtung (103); und
   b) Berechnen (205), durch die elektronische Verwaltungsvorrichtung (103), eines Wertes, der repräsentativ ist für den zukünftigen Gesundheitszustand der Batterie, unter Berücksichtigung des in Schritt a) gemessenen Nutzungsprofils, basierend auf einem vordefinierten Batteriealterungsmodell,

   **dadurch gekennzeichnet, dass** das Alterungsmodell, gespeichert in einer Speicherschaltung der elektronischen Verwaltungsvorrichtung (103), Folgendes aufweist eine erste vordefinierte Alterungstabelle, die die kalendarische Alterung der Batterie modelliert, und eine zweite vordefinierte Alterungstabelle, die die Alterung durch Zyklisieren der Batterie modelliert, wobei die erste Alterungstabelle eine dreidimensionale Tabelle ist, die für jede Kombination eines Zustandswertes, eines Ladezustandswertes und eines Temperaturwertes unter:

- einer Vielzahl von vordefinierten Zustandswerten;
- einer Vielzahl von vordefinierten Werten für den Ladezustand; und
- einer Vielzahl von vordefinierten Temperaturwerten, einen Wert enthält der repräsentativ ist für den Verlust der Batteriekapazität während eines vordefinierten Zeitintervalls,

wobei die zweite Alterungstabelle eine vierdimensionale Tabelle ist, die für jede Kombination eines Gesundheitszustandswerts, eines Ladezustandswerts, eines Temperaturwerts und eines Werts eines Vorspannungsstroms der Batterie unter:

- einer Vielzahl von vordefinierten Zustandswerten;
- einer Vielzahl von vordefinierten Ladezustandswerten;
- einer Vielzahl von vordefinierten Temperaturwerten; und
- einer Vielzahl von vordefinierten Werten des Vorspannungsstroms der Batterie,

einen Wert enthält, der für den Verlust der Batteriekapazität während eines vordefinierten Zeitintervalls repräsentativ ist,
und wobei die elektronische Verwaltungsvorrichtung (103) konfiguriert ist zum in Schritt b) Schätzen, aus dem Modell und gemäß dem in Schritt a) gemessenen Nutzungsprofil, eines zukünftigen Verlustes an Batteriekapazität und Ableiten daraus des Werts, der den zukünftigen Gesundheitszustand der Batterie darstellt.

**Claims**

1. Electric battery (100) comprising an electronic management device (103) configured to:

   a) measure and store a battery use profile; and
   b) calculate a value representative of the future state of health of the battery (100) taking into account said use profile measured in step a), based on a predefined battery aging model,

   **characterised in that** the aging model comprises, stored in a memory circuit of the electronic management device (103), a first predefined aging table modelling the calendar aging of the battery and a second predefined aging table modelling the aging by cycling of the battery, wherein the first aging table is a three-dimensional table containing, for each combination of a state of health value, of a state of charge value, and of a temperature value among:

   - a plurality of predefined state of health values;
   - a plurality of predefined state of charge values; and
   - a plurality of predefined temperature values, a value representative of the loss of battery capacity during a predefined time interval,

   wherein the second aging table is a four-dimensional table containing, for each combination of a state of health value, of a state of charge value, of a temperature value, and of a value of a biasing current of the battery among:

   - a plurality of predefined state of health values;
   - a plurality of predefined state of charge values;
   - a plurality of predefined temperature values; and
   - a plurality of predefined values of biasing current of the battery,

   a value representative of the loss of battery capacity during a predefined time interval,
   and wherein the electronic management device (103) is configured to, in step b), estimate, from the model and according to the use profile measured in step a), a future loss of battery capacity, and deducing therefrom said value representative of the future state of health of the battery.

2. Battery of claim 1, wherein the electronic management device (103) is configured to reiterate step b) successively a plurality of times by modifying at each iteration the prediction horizon, so as to determine an estimated battery lifetime.

3. Method implemented in an electric battery (100) comprising an electronic management device (103), comprising the following steps:

a) measuring and storing (203), through the electronic management device (103), a battery use profile; and
b) calculating (205), through the electronic management device (103), a value representative of the future state of health of the battery taking into account the use profile measured in step a), based on a predefined battery aging model,

**characterised in that** the aging model comprises, stored in a memory circuit of the electronic management device (103), a first predefined aging table modelling the calendar aging of the battery and a second predefined aging table modelling the aging by cycling of the battery, wherein the first aging table is a three-dimensional table containing, for each combination of a state of health value, of a state of charge value, and of a temperature value among:

- a plurality of predefined state of health values;
- a plurality of predefined state of charge values; and
- a plurality of predefined temperature values, a value representative of the loss of battery capacity during a predefined time interval,

wherein the second aging table is a four-dimensional table containing, for each combination of a state of health value, of a state of charge value, of a temperature value, and of a value of a biasing current of the battery among:

- a plurality of predefined state of health values;
- a plurality of predefined state of charge values;
- a plurality of predefined temperature values; and
- a plurality of predefined values of biasing current of the battery,

a value representative of the loss of battery capacity during a predefined time interval,
and wherein the electronic management device (103) is configured to, in step b), estimate, from the model and according to the use profile measured in step a), a future loss of battery capacity, and deducing therefrom said value representative of the future state of health of the battery.

101

103

CEL — BMS

Fig 1

100

Fig 2

201

203

Initialisation du profil d'utilisation → Mise à jour du profil d'utilisation

Prédiction SOH

205

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2010250162 A1
- US 2018059192 A1
- DE 102014200645 A1

**Littérature non-brevet citée dans la description**

- **POURMOUSAVI S ALI.** *A novel algorithm to integrated battery cyclic and calendar agings within a single framework*
- **BREMER ILKA.** *Investigation of li-ion battery state of health détection in electric vehicles - a comparison of simulation results and field measurement*